# NOUVEAU FASCICULE DE BREVET EUROPEEN

(11) **EP 1 613 795 B2**
(45) Date de publication et mention de la décision concernant l'opposition: **02.06.2010**
(45) Mention de la délivrance du brevet: 03.01.2007
(21) Numéro de dépôt: 04742479.1
(22) Date de dépôt: 09.04.2004
(51) Int. Cl.: C30B 11/00

(54) **CREUSET POUR UN DISPOSITIF DE FABRICATION D’UN BLOC DE MATERIAU CRISTALLIN ET PROCEDE DE FABRICATION**
TIEGEL FÜR EINE VORRICHTUNG ZUR HERSTELLUNG EINES KRISTALLINEN BLOCKES, UND VERFAHREN ZU SEINER HERSTELLUNG
CRUCIBLE FOR A DEVICE USED FOR THE PRODUCTION OF A BLOCK OF CRYSTALLINE MATERIAL, AND PRODUCTION METHOD

(30) Priorité: 17.04.2003 FR 0304803
(43) Date de publication de la demande: 11.01.2006
(73) Titulaire: Apollon Solar, 75017 Paris (FR); Cyberstar, 38130 Echirolles (FR); EFD Induction SA, 38170 Seyssinet Pariset (FR)
(72) Inventeur: EINHAUS, Roland, F-38300 Bourgoin Jallieu (FR); LISSALDE, François, F-38180 Seyssins (FR); RIVAT, Pascal, F-38590 Saint Etienne de Saint Geoirs (FR)
(74) Mandataire: Hecké, Gérard
(86) Numéro de dépôt international: PCT/FR2004/000894
(87) Numéro de publication internationale: WO 2004/094704

(56) Documents cités:
- EP-A- 0 424 981
- DE-A- 2 543 752
- DE-A- 4 236 827
- FR- - 2 302 132
- FR-A- 2 487 863
- FR-A- 2 509 638
- GB-A- 2 218 789
- US-A- 6 165 425
- PATENT ABSTRACTS OF JAPAN vol. 1995, no. 04, 31 mai 1995 (1995-05-31) & JP 07 010672 A (SHIN ETSU CHEM CO LTD), 13 janvier 1995 (1995-01-13) cité dans la demande
- PATENT ABSTRACTS OF JAPAN vol. 1998, no. 10, 31 août 1998 (1998-08-31) & JP 10 139580 A (JAPAN STEEL WORKS LTD:THE), 26 mai 1998 (1998-05-26)
- PATENT ABSTRACTS OF JAPAN vol. 2000, no. 15, 6 avril 2001 (2001-04-06) & JP 2000 351688 A (MITSUBISHI MATERIALS CORP), 19 décembre 2000 (2000-12-19)
- 'Fused Silica Design Manual', vol. 1, Mai 1973, ATLANTA, GEORGIA article J.N.HARRIS, E.A.WELSH

## Description

### Domaine technique de l'invention

L'invention concerne un creuset pour un dispositif de fabrication d'un bloc de matériau cristallin par cristallisation dirigée, présentant des parois latérales et un fond, le fond ayant, parallèlement à un axe sensiblement perpendiculaire au fond, des propriétés de transfert thermique très supérieures à celles des parois latérales selon ledit axe.

### État de la technique

Les technologies classiques d'obtention de silicium solide multi-cristallin pour application photovoltaïque trouvent leur limitation
- économiquement par le temps de cristallisation nécessaire, lié au volume et à la hauteur du bloc en silicium,
- techniquement par les performances des dispositifs semi-conducteurs, liées à la longueur de diffusion des porteurs minoritaires,
- par des croissances non-contrôlées latérales générant des pertes matières et nécessitant un écroûtage,
- par la diffusion des impuretés du creuset dans le silicium, nécessitant un écroûtage.

Afin d'apporter des améliorations à ces limitations, des efforts considérables ont été faits dans la conception des fours et la qualité du matériau à solidifier. Ainsi, la purification plasma et la conception de fours permettant une ségrégation des impuretés métalliques, ont, certes, permis d'améliorer les performances de cellules solaires ainsi obtenues, mais ont toujours trouvé une limitation technico-économique dans le volume et la hauteur du bloc en silicium cristallisé.

La solidification du silicium à partir d'un bain de silicium liquide, est obtenue typiquement par cristallisation dirigée, c'est-à-dire par migration d'un front de solidification (interface solide/liquide) à partir d'une partie initialement solidifiée, notamment un germe ou une première couche cristallisée par refroidissement local. Ainsi, le bloc de silicium solide croît progressivement en se nourrissant du bain liquide. Les deux procédés classiquement utilisés sont le procédé de Czochralski, le procédé de Bridgman ou leurs variantes. Selon le procédé de Czochralski, un germe, souvent orienté par rapport à un axe cristallin du silicium solide, est trempé dans le bain fondu pour être remonté lentement. Le bain de silicium liquide et le gradient thermique restent alors immobiles, tandis que selon le procédé de type Bridgman, on déplace le bain par rapport au gradient thermique, ou bien le gradient thermique par rapport au bain.

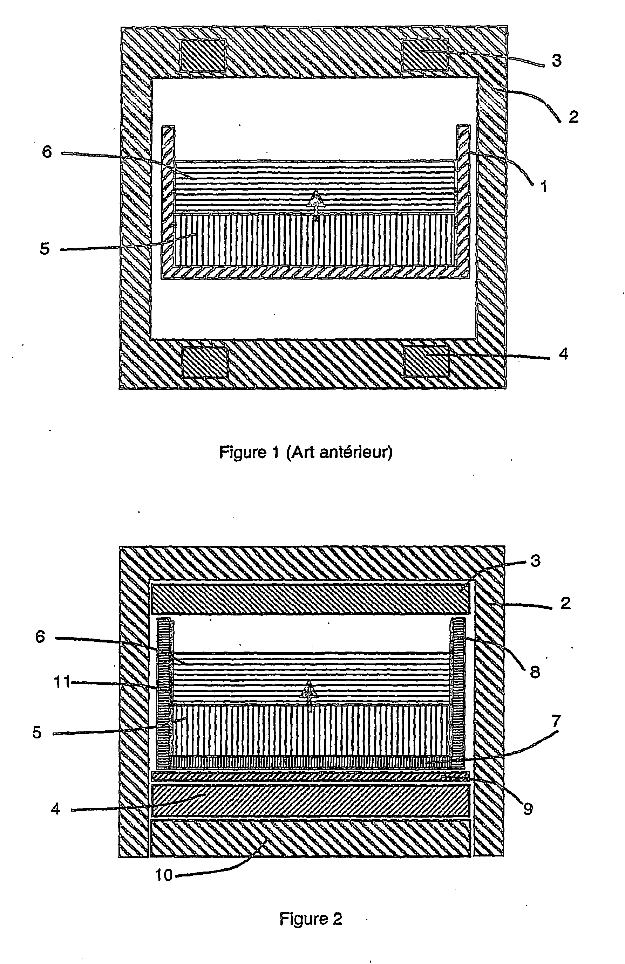

La présente invention concerne le procédé de Bridgman. Comme représenté à la figure 1, un récipient contenant le silicium est classiquement constitué par un creuset 1 moulé en quartz, disposé dans un boîtier isolant 2 en matériau isolant. Un gradient thermique est créé entre des moyens de chauffage 3, disposés à la partie supérieure du boîtier isolant 2, et des moyens de refroidissement 4, disposés à la partie inférieure du boîtier isolant 2. Le silicium solide 5, obtenu à partir du silicium liquide 6, présente souvent des inhomogénéités, par exemple une structure en fines particules (« microgrit ») n'ayant pas atteint la taille critique du germe de cristallisation et se trouvant sous forme d'amas, ce qui réduit la longueur de diffusion des porteurs minoritaires. Un autre problème est la création de poches liquides, due aux périodes critiques de fin de cristallisation, phénomène désastreux bien connu de l'homme de l'art. De plus, les surfaces isothermes dans le silicium ne présentent pas des plans parallèles, ce qui détériore également la qualité du silicium solide obtenu.

Le document JP 07010672 décrit un creuset en platine installé dans un four électrique pour la croissance de monocristaux selon la méthode de Bridgman. Le creuset contient un liquide amené en contact avec un cristal servant de germe de cristallisation et disposé dans la partie inférieure du creuset. Une substance transparente est installée sous le cristal. Le matériau du creuset est réflecteur. Un tel creuset est difficile à mettre en oeuvre.

Le document FR 2509638 décrit un moule pour le moulage de lingots de silicium destinés à être utilisés comme matériau pour la réalisation de cellules solaires. Le moule comporte, dans une enveloppe externe métallique, un revêtement épais, isolant thermiquement, par exemple en fibres céramiques, disposé autour des parois latérales minces d'un récipient, en fibres de graphite ou en céramique. Une couche de fond, par exemple en sable siliceux, est disposée sous le récipient. Un tel moule est complexe et encombrant.

### Objet de l'invention

L'invention a pour but de remédier à ces inconvénients et, en particulier, un dispositif et un procédé de fabrication d'un bloc de matériau cristallin par cristallisation dirigée, permettant d'obtenir, en particulier, du silicium multi-cristallin suffisamment pur et avec une structure cristalline adaptée aux applications photovoltaïques, tout en réduisant les coûts de la fabrication.

Selon l'invention, ce but est atteint par les revendications annexées et, plus particulièrement, par le fait que le fond et les parois latérales sont constitués par des matériaux ayant les mêmes constituants chimiques principaux.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels:
La figure 1 montre un dispositif de fabrication d'un bloc de matériau cristallin par cristallisation dirigée selon l'art antérieur.
La figure 2 montre un dispositif selon l'invention comportant un creuset selon l'invention.

### Description de modes particuliers de réalisation

Le dispositif de fabrication d'un bloc de matériau cristallin par cristallisation dirigée, représentée à la figure 2, comporte un assemblage ou un boîtier isolant 2 et un creuset dont le fond 7 est solidaire des parois latérales 8. Le fond 7 et les parois latérales forment alors une seule pièce. Le fond 7 a des propriétés de transfert thermique, parallèlement à un axe sensiblement perpendiculaire au fond 7, très supérieures à celles des parois latérales 8 du creuset, selon ledit axe. Les propriétés de transfert thermique englobent, d'une part, la conductivité thermique du matériau et, d'autre part, son coefficient de transmission du rayonnement infrarouge. Le fond 7 et les parois latérales 8 sont constitués par des matériaux ayant les mêmes constituants chimiques principaux. Ainsi, le fond 7 peut être lié, sans difficulté, par exemple soudé, aux parois latérales 8 et les coefficients de dilatation thermiques des matériaux sont sensiblement les mêmes. Le constituant principal de chacun des matériaux peut, par exemple, être l'entité chimique SiO₂, l'agencement dans l'espace des entités chimiques SiO₂ constituant le fond 7 étant différent de l'agencement dans l'espace des entités chimiques SiO₂ constituant les parois latérales 8.

Des moyens de chauffage 3 et des moyens de refroidissement 4 sont respectivement constitués par une résistance chauffante disposée au-dessus du creuset, dans le boîtier isolant 2, et par un échangeur de chaleur, disposé sous le creuset, dans le boîtier isolant 2. La résistance chauffante et l'échangeur de chaleur sont suffisamment larges pour couvrir complètement le creuset. Les moyens de chauffage peuvent également être constitués par des moyens de chauffage par induction.

Par la suite, plusieurs modes de réalisation particuliers sont décrits en référence à la fabrication d'un bloc de silicium. Cependant, l'invention s'applique à tout type de matériau cristallin.

Dans un mode de réalisation particulier, le fond 7 du creuset est transparent au rayonnement infrarouge, tandis que les parois latérales 8 sont opaques au rayonnement infrarouge. Un tel creuset peut être constitué d'un fond 7 en silice amorphe et de parois latérales 8 en céramique de quartz opaque. Les matériaux ont SiO₂ comme constituant principal et ne se distinguent que par leur structure cristallographique et l'agencement des constituants SiO₂ dans l'espace. Ainsi, le rayonnement infrarouge, émis par le silicium solide 5 contenu dans le creuset, est transmis à l'échangeur 4 de chaleur à travers la silice amorphe, transparente, ce qui permet d'évacuer la chaleur du silicium solide 5 et d'établir dans le creuset un gradient thermique d'au moins 8°C/cm. En effet, un gradient thermique prédéterminé nécessite une évacuation de chaleur efficace, proportionnelle au gradient thermique. L'opacité des parois latérales 8, par contre, empêche l'échange de rayonnement infrarouge par l'intermédiaire des parois, qui entraînerait la convection du silicium liquide. Ainsi, les surfaces isothermes sont sensiblement planes et parallèles et, par conséquent, le front de solidification est également sensiblement plan, parallèlement au fond 7 du creuset.

Lors de la fabrication du creuset, les parois latérales 8 en céramique de quartz opaque et le fond 7 en silice amorphe sont rendues solidaires, par exemple, en chauffant les parties, respectivement des parois latérales 8 et du fond 7, destinées à former la jonction. La température de chauffage est supérieure à la température de fusion des matériaux, de l'ordre de 2000°C et ceci peut être réalisé par l'intermédiaire d'un chalumeau. Les matériaux se lient alors intimement.

Il est à noter que les conductivités thermiques de la silice amorphe, d'une part, et de la céramique de quartz opaque, d'autre part, sont pratiquement du même ordre, environ 2 W/(m°C). La différence de transfert thermique est alors uniquement due à la transparence au rayonnement infrarouge.

Lors de la cristallisation du silicium, l'épaisseur de la phase solide augmente, de manière à ce que le front de solidification progresse vers le haut en s'éloignant du fond de creuset. La température de fusion de silicium étant de 1410°C, la surface isotherme de 1410°C s'éloigne alors du fond du creuset, ce qui conduit à une diminution de la température au fond du creuset au cours du procédé de cristallisation. Or, la puissance émise par rayonnement par un corps quelconque diminue avec la température.

Afin que la puissance thermique évacuée par les moyens de refroidissement 4 reste sensiblement constante pendant la durée de solidification, on peut intégrer dans le dispositif un feutre de graphite 9 (figure 2), disposé entre le fond du creuset et les moyens de refroidissement 4, et des moyens 10 de compression du feutre de graphite pendant la solidification du silicium. Sur la figure 2, les moyens de refroidissement 4 et le feutre de graphite 9 sont disposés entre les moyens 10 de compression et le creuset, de manière à ce que les moyens de compression 10 exercent une pression contre le creuset et les moyens de refroidissement. Ainsi, l'épaisseur du feutre de graphite 9 diminue et sa conductivité thermique augmente. Le transfert thermique par conductivité du feutre de graphite 9 peut alors être contrôlé par les moyens de compression 10. Au cours du procédé de solidification, la force de compression peut être augmentée progressivement pour compenser la diminution du transfert thermique par rayonnement à travers le fond du creuset. Par conséquent, lors du procédé de solidification, le gradient thermique dans le creuset peut être contrôlé et maintenu à une valeur comprise entre 8°C/cm et 30°C/cm, et de préférence entre 10°C/cm et 20°C/cm, ce qui permet d'augmenter la vitesse de cristallisation. L'épaisseur du feutre de graphite non-comprimé est de 5mm, tandis que son épaisseur est de 3,5 mm sous compression.

L'échangeur de chaleur comporte typiquement un circuit de fluide caloporteur et, selon les applications, le fluide peut être de l'huile de synthèse ayant, par exemple, une température d'utilisation inférieure à 300°C ou un fluide fonctionnant à haute température, par exemple un gaz sous pression, par exemple de l'hélium. Il est possible de faire varier la température du fluide caloporteur de manière contrôlée, afin d'assurer que la puissance évacuée reste constante pendant la durée de solidification.

Dans un autre mode de réalisation particulier, le fond 7 et les parois latérales 8 sont constitués par des plaques réalisées dans un même matériau ayant des propriétés anisotropes de conduction thermique. La conductivité thermique des plaques, dans le plan des plaques, est très inférieure à leur conductivité thermique perpendiculairement à ce plan. Par exemple, le creuset peut être réalisé avec un graphite ayant des propriétés fortement anisotropes, dues à sa structure géométrique. On peut notamment réaliser un creuset, dont le fond et les parois latérales sont constitués par des plaques de graphite ayant une conductivité thermique faible dans le plan des plaques et élevée dans une direction perpendiculaire au plan. Ainsi, l'énergie thermique du silicium est transmise à l'échangeur de chaleur par conduction à travers le fond 7, tandis que la conduction thermique dans les parois latérales est très faible parallèlement à un axe sensiblement perpendiculaire au fond. Ce mode de réalisation permet également d'établir un gradient thermique d'au moins 8°C/cm et de réaliser un front de solidification sensiblement plan.

Dans un mode de réalisation préférentiel, le creuset comporte un revêtement 11 sur une face interne et/ou une face externe des parois latérales, ce qui permet de modifier les propriétés de transfert thermique des parois latérales. En effet, un dépôt de nitrure de silicium sur la face interne des parois latérales 8, par exemple, permet de diminuer l'émissivité des parois latérales 8 et ainsi, de réduire le transfert thermique par rayonnement. Un revêtement comportant un matériau réfléchissant disposé sur la face externe des parois latérales 8, permet également de diminuer le transfert thermique à travers les parois latérales 8.

Selon un exemple numérique, non limitatif, un creuset carré de côté de 450mm et de hauteur de 250mm est rempli de 50 litres de silicium liquide, ce qui correspond à 128 kg de silicium. Typiquement, l'épaisseur des parois latérales du creuset est de 10mm et l'épaisseur du fond du creuset est de 10 mm. La cristallisation s'effectue avantageusement à une vitesse déterminée de 20mm/h et dure, par conséquent, 12 heures et 30 minutes. La différence de température initiale entre le haut et le bas du creuset est de 375°C, ce qui correspond à un gradient thermique de 15°C/cm dans la phase liquide. La puissance P_{J} dissipée par effet Joule dans la résistance de chauffage est essentiellement récupérée au niveau de l'échangeur de chaleur situé sous le creuset, en négligeant les pertes thermiques transmises par le boîtier isolant 2 vers l'extérieur. En plus de la puissance P_{J}, une puissance P_{L}, restituée lors de la cristallisation par la chaleur latente de la transition liquide/solide, est récupérée au niveau de l'échangeur de chaleur. La puissance P_{J}, dépendant du gradient thermique dans la phase liquide et de la conductivité du silicium liquide (56 W/(m°C)), est de l'ordre de 17 kW pour le dispositif considéré dans l'exemple, tandis que la puissance P_{L}, dépendant de la vitesse de cristallisation, est de l'ordre de 5 kW, la puissance évacuée dans l'échangeur étant alors de l'ordre de 22kW. En considérant un fond 7 de creuset complètement transparent, une puissance thermique de 22kW peut être évacuée par rayonnement par un échangeur de chaleur maintenu à une température de 20°C, pour une température du silicium solide de 1150°C au fond du creuset, l'émissivité du silicium étant d'environ 0,5.

L'invention permet une cristallisation contrôlée de silicium multi-cristallin, suffisamment pur et avec une structure cristalline adaptée aux applications photovoltaïques. L'invention permet également d'obtenir une vitesse de cristallisation plus rapide pour produire un bloc de silicium multi-cristallin d'une hauteur plus importante que la hauteur obtenue avec les techniques connues et ainsi d'arriver à une plus grande efficacité des fluides utilisés pour les moyens de refroidissement. Grâce au gradient thermique compris entre 8°C/cm et 30°C/cm, à l'anisotropie thermique du creuset et au montage thermique autour du creuset, le front de solidification est mieux stabilisé, la ségrégation des impuretés métalliques est améliorée et la taille ainsi que la structure des grains cristallins sont améliorées. En résultat, le silicium multi-cristallin ainsi obtenu est caractérisé par une longueur de diffusion des porteurs minoritaires plus importante grâce à laquelle les performances des dispositifs photovoltaïques sont augmentées.

## Revendications

1. Creuset pour un dispositif de fabrication d'un bloc de matériau cristallin par cristallisation dirigée, présentant des parois latérales (8) et un fond (7), le fond (7) ayant, parallèlement à un axe sensiblement perpendiculaire au fond (7), des propriétés de transfert thermique très supérieures à celles des parois latérales (8) selon ledit axe, creuset **caractérisé en ce que** le fond (7) et les parois latérales (8) sont constitués par des matériaux ayant les mêmes constituants chimiques principaux et **en ce que** le fond (7) est transparent au rayonnement infrarouge, les parois latérales (8) étant opaques au rayonnement infrarouge.

2. Creuset selon la revendication 1, **caractérisé en ce que** le fond (7) est en silice amorphe, les parois latérales (8) étant en céramique de quartz opaque.

3. Creuset selon l'une des revendications 1 et 2, **caractérisé en ce que** le creuset comporte au moins un revêtement (11) sur au moins une face des parois latérales (8).

4. Creuset selon la revendication 3, **caractérisé en ce que** le matériau du revêtement (11) est choisi parmi le nitrure de silicium et les matériaux réfléchissants.

5. Dispositif de fabrication d'un bloc de matériau cristallin par cristallisation dirigée, comportant un creuset disposé dans un boîtier isolant (2) entre des moyens de chauffage (3) disposés au-dessus du creuset et des moyens de refroidissement (4) disposés au-dessous du creuset, dispositif **caractérisé en ce que** le creuset est un creuset selon l'une quelconque des revendications 1 à 4.

6. Dispositif selon la revendication 5, **caractérisé en ce qu'**il comporte un feutre de graphite (9), disposé entre le fond (7) du creuset et les moyens de refroidissement (4), et des moyens de compression (10) pour comprimer le feutre de graphite (9) pendant la cristallisation du matériau cristallin.

7. Procédé de fabrication d'un bloc de matériau cristallin par cristallisation dirigée, **caractérisé en ce qu'**il utilise un dispositif selon l'une quelconque des revendications 5 et 6, de manière à définir un gradient thermique compris entre 8°C/cm et 30°C/cm dans la phase liquide.

## Claims

1. Crucible for a device for producing a block of crystalline material by directed crystallization, presenting side walls (8) and a bottom (7), the bottom (7) having, parallel to a direction substantially perpendicular to the bottom (7), much greater heat transfer properties than those of the side walls (8) along said direction, crucible **characterized in that** the bottom (7) and side walls (8) are formed by materials having the same main chemical constituents and **in that** the bottom (7) is transparent to infrared radiation, the side walls (8) being opaque to infrared radiation.

2. Crucible according to claim 1, **characterized in that** the bottom (7) is made of amorphous silica, the side walls (8) being made of opaque quartz ceramic.

3. Crucible according to one of the claims 1 and 2, **characterized in that** the crucible comprises at least one coating (11) on at least one face of the side walls (8).

4. Crucible according to claim 3, **characterized in that** the material of the coating (11) is chosen from silicon nitride and reflecting materials.

5. Device for producing a block of crystalline material by directed crystallization, comprising a crucible arranged in an insulating enclosure (2) between heating means (3) arranged above the crucible and cooling means (4) arranged below the crucible, device **characterized in that** the crucible is a crucible according to any one of the claims 1 to 4.

6. Device according to claim 5, **characterized in that** it comprises a graphite felt (9), arranged between the bottom (7) of the crucible and the cooling means (4), and compression means (10) to compress the graphite felt (9) during crystallization of the crystalline material.

7. Method for producing a block of crystalline material by directed crystallization, **characterized in that** it uses a device according to any one of the claims 5 and 6, so as to define a temperature gradient comprised between 8°C/cm and 30°C/cm in the liquid phase.

## Patentansprüche

1. Tiegel für eine Vorrichtung zur Herstellung eines Blocks aus kristallinem Material durch gerichtete Kristallisation, der Seitenwände (8) und einen Boden (7) aufweist, wobei der Boden (7) parallel zu einer im Wesentlichen lotrecht zum Boden (7) verlaufenden Achse thermische Übertragungseigenschaften aufweist, die erheblich über denen der Seitenwände (8) entlang der genannten Achse liegen, ein Tiegel, der **dadurch gekennzeichnet ist, dass** der Boden (7) und die Seitenwände (8) aus Materialien mit gleichen chemischen Hauptbestandteilen bestehen, und dass der Boden (7) für Infrarotstrahlung durchlässig ist und die Seitenwände (8) für Infrarotstrahlung undurchlässig sind.

2. Tiegel nach Anspruch 1, **dadurch gekennzeichnet, dass** der Boden (7) aus amorpher Kieselerde besteht und die Seitenwände (8) aus optisch dichter Quarzkeramik bestehen.

3. Tiegel nach einem der Ansprüche 1 und 2, **dadurch gekennzeichnet, dass** der Tiegel mindestens eine Beschichtung (11) auf mindestens einer Seite der Seitenwände (8) aufweist.

4. Tiegel nach Anspruch 3, **dadurch gekennzeichnet, dass** das Material der Beschichtung (11) aus Siliziumnitrid und reflektierenden Materialien ausgewählt ist.

5. Vorrichtung zur Herstellung eines Blocks aus kristallinem Material durch gerichtete Kristallisation, die einen Tiegel aufweist, der in einem isolierenden Gehäuse (2) zwischen über dem Tiegel angeordneten Heizmitteln (3) sowie unter dem Tiegel angeordneten Kühlmitteln (4) angeordnet ist, eine Vorrichtung, die **dadurch gekennzeichnet ist, dass** der Tiegel ein Tiegel nach einem der Ansprüche 1 bis 4 ist.

6. Vorrichtung nach Anspruch 5, **dadurch gekennzeichnet, dass** sie eine Graphitmatte (9) umfasst, die zwischen dem Boden (7) des Tiegels und den Kühlmitteln (4) angeordnet ist, sowie Kompressionsmittel (10) zum Komprimieren der Graphitmatte (9) während der Kristallisation des kristallinen Materials.

7. Herstellungsverfahren für einen Block aus kristallinem Material durch gerichtete Kristallisation, **dadurch gekennzeichnet, dass** es eine Vorrichtung nach einem der Ansprüche 5 und 6 verwendet, um in der flüssigen Phase einen Wärmegradienten von 8°C/cm bis 30°C/cm zu definieren.
